# EUROPÄISCHE PATENTSCHRIFT

(11) **EP 3 510 710 B1**
(45) Veröffentlichungstag und Bekanntmachung des Hinweises auf die Patenterteilung: **26.04.2023**
(21) Anmeldenummer: 17752364.4
(22) Anmeldetag: 09.08.2017
(51) Int. Cl.: H04B 10/80, G01S 7/48, H01L 25/16, H01L 31/153, H03K 17/78

(54) **OPTOKOPPLER MIT EINER OPTISCHEN ÜBERTRAGUNGSSTRECKE UND ELEKTRISCHEN ANSCHLÜSSEN UND ELEKTRONISCHE BAUGRUPPE, IN DER EIN SOLCHER OPTOKOPPLER EINGEBAUT IST**
OPTOCOUPLER HAVING AN OPTICAL TRANSMISSION LINK AND ELECTRICAL CONNECTIONS, AND ELECTRONIC MODULE IN WHICH SUCH AN OPTOCOUPLER IS INSTALLED
OPTOCOUPLEUR POURVU D'UN CHEMIN OPTIQUE DE TRANSMISSION ET DE CONNEXIONS ÉLECTRIQUES ET MODULE ÉLECTRONIQUE, DANS LEQUEL UN TEL OPTOCOUPLEUR EST INCORPORÉ

(30) Priorität: 06.09.2016 DE 102016216811
(43) Veröffentlichungstag der Anmeldung: 17.07.2019
(73) Patentinhaber: Siemens Energy Global GmbH & Co. KG, 81739 München (DE)
(72) Erfinder: BEIER, Axel, 16552 Schildow (DE); NERRETER, Stefan, 15754 Heidesee OT Blossin (DE)
(86) Internationale Anmeldenummer: PCT/EP2017/070126
(87) Internationale Veröffentlichungsnummer: WO 2018/046216

(56) Entgegenhaltungen:
- DE-B3-102004 029 694
- JP-A- 2008 182 155
- US-A- 4 450 461
- US-A1- 2004 149 995
- US-A1- 2007 019 899
- US-A1- 2013 315 533

## Beschreibung

Die Erfindung betrifft eine elektronische Baugruppe mit einem Optokoppler, der einen Sender und einen Empfänger aufweist, die durch eine optische Übertragungsstrecke miteinander gekoppelt sind. Der Optokoppler weist überdies elektrische Anschlüsse am Sender und Empfänger auf, wobei der Sender mit einem elektrischen Strom versorgt werden kann und der Empfänger über die elektrischen Anschlüsse ein elektrisches Signal ausgeben kann. Außerdem betrifft die Erfindung eine elektronische Baugruppe mit einer ersten Schaltung und einer zweiten Schaltung, wobei die erste Schaltung galvanisch von der zweiten Schaltung getrennt ist. Dies bedeutet, dass keine elektrischen Ströme zwischen der ersten Schaltung und der zweiten Schaltung ausgetauscht werden können. Außerdem ist zwischen der ersten Schaltung und der zweiten Schaltung eine optische Übertragungsstrecke vorgesehen. Diese überbrückt die galvanische Trennung zwischen den beiden genannten Schaltungen, wobei die galvanische Trennung auch als galvanischer Graben bezeichnet wird. Der galvanische Graben kann ein wirklicher Graben oder eine anders geartete elektrische Isolationsstrecke sein, wobei die Breite des galvanischen Grabens aus den technischen Anforderungen der Baugruppe abgeleitet werden kann. Eine galvanische Trennung ist z. B. zwischen Leistungsbauelementen auf der einen Seite und Steuerungsbauelementen zur Ansteuerung der Leistungsbauelemente auf der anderen Seite des galvanischen Grabens erforderlich.

Ein Optokoppler und eine elektronische Baugruppe der eingangs angegebenen Art sind beispielsweise aus der EP 2 515 453 A1 bekannt. Es wird beschrieben, dass für leistungselektronische Umrichter ein optisches Kommunikationssystem verwendet werden kann. Derartige Komponenten werden häufig in Schaltschränke eingebaut, wobei eine optische Übertragungsstrecke zwischen optischen Sendern und Empfängern beispielsweise über Lichtwellenleiter erfolgen kann. Allerdings wird in dem genannten Dokument kritisiert, dass der Komponentenaufwand durch Verwendung der Lichtwellenleiter und hierfür geeignete Koppelstellen in nicht wünschenswerter Weise erhöht wird, daher wird gemäß dem genannten Dokument vorgeschlagen, dass auf Lichtwellenleiter verzichtet wird und als optisches Medium zur Übertragung von Lichtsignalen vom Sender zum Empfänger die im Schaltschrank befindliche Luft genutzt wird. Die hiermit zwangsläufig verbundenen höheren optischen Verluste einer Übertragung werden im Interesse der Wirtschaftlichkeit der Lösung in Kauf genommen. Hierdurch wird im Übrigen auch die übertragbare Datenrate begrenzt.

Aus US 2013/0315533 A1 ist eine optoelektronische Vorrichtung bekannt. Die optoelektronische Vorrichtung kann als ein- oder mehrkanaliger Optokoppler eingesetzt werden, der eine Schaltung von einer anderen elektrisch trennt. Der Optokoppler kann eine oder mehrere vorgeformte Hohlräume mit einem darin enthaltenen Lichtkopplungsmedium beinhalten. Wände der einen oder mehreren vorgeformten Hohlräumen tragen vorteilhaft dazu bei, das Lichtkopplungsmedium während der Herstellung zu formen, was zu einem Lichtweg mit kontrollierter Form und Abmessung führt.

Aus DE 10 2004 029 694 B3 ist ein elektrooptischer Bauteilverbund bekannt, der z. B. aus einem aktiven optischen Bauelement und einem optischen Umlenkelement bestehen kann.

Aus US 2007/0019899 A1 ist eine Sub-Halterung zur Montage einer optischen Komponente bekannt. Weiterhin sind Lichtsende- und Empfangsmodule und ein Herstellungsverfahren der Sub-Halterung zur Montage der optischen Komponente, insbesondere auf eine Sub-Halterung, die in einem Gehäuse einer optischen Vorrichtung montiert ist sowie ein Lichtsende- und Empfangsmodul unter Verwendung der Sub-Halterung und ein Herstellungsverfahren der Sub-Halterung gezeigt.

Die Schrift US 2004/0149995 A1 offenbart einen Optokoppler mit einem lichtaussendenden Element und einem lichtempfangenden Element, die in einem transparenten Kunstharz angeordnet sind. Das lichtaussendende Element, das lichtempfangende Element und das transparente Kunstharz sind von einem Gehäuse aus einem lichtundurchlässigen Kunstharz umschlossen. Aus dieser Schrift sind die Merkmale des Oberbegriffs von Anspruch 1 bekannt.

Die Schrift US 4 450 461 A offenbart einen Optokoppler, der ein lichtaussendendes Element und ein lichtdetektierendes Element aufweist. Das lichtaussendende Element und das lichtdetektierende Element sind mit jeweils einem Ende eines Stabes aus einem lichtdurchlässigen dielektrischen Material verbunden.

Die Aufgabe der Erfindung besteht darin, eine elektronische Baugruppe der eingangs angegebenen Art derart zu verbessern, dass eine optische Übertragung einerseits mit kostengünstigen Komponenten und andererseits mit hoher optischer Übertragungsgüte möglich ist.

Diese Aufgabe wird mit einer elektronischen Baugruppe gemäß Anspruch 1 gelöst. Bei dieser elektronischen Baugruppe mit einer ersten Schaltung und einer zweiten Schaltung, wobei die erste Schaltung galvanisch von der zweiten Schaltung getrennt ist, ist erfindungsgemäß zwischen der ersten Schaltung und der zweiten Schaltung eine optische Übertragungsstrecke vorgesehen, wobei der Optokoppler die optische Übertragungsstrecke zur Verfügung stellt. Der Optokoppler weist einen Schaltungsträger auf, wobei der Sender, der Empfänger und ein Lichtleitelement in der optischen Übertragungsstrecke als SMD-Bauteile ausgeführt sind und in einer Anordnung auf dem Schaltungsträger montiert sind, dass Lichtsignale des Senders in das Lichtleitelement eingekoppelt werden und aus dem Lichtleitelement ausgekoppelte Lichtsignale auf den Empfänger treffen (SMD steht für Surface Mounted Device, es handelt sich um oberflächenmontierbare Bauteile, die mittels Verfahren der Oberflächenmontage oder in Surface Mounted Technology, kurz SMT montiert werden können). Vorzugsweise kann der Schaltungsträger selbst als SM-Bauteil ausgeführt sein, so dass sich dieser leicht am gewünschten Einbauort montieren und elektrisch kontaktieren lässt, wobei hierbei die Toleranzanforderungen der Elektronikmontage gelten. Die höheren Toleranzanforderungen der Optikmontage müssen nicht gewährleistet werden, da Sender, Empfänger und Lichtleitelement bereits auf dem Schaltungsträger vormoniert sind. Bei dem Lichtleitelement handelt es sich um einen Lichtwellenleiter, welcher eine hohe optische Übertragungsgüte bei gleichzeitig geringen optischen Verlusten ermöglicht. Daher lassen sich auch hohe Datenraten im Bereich größer als 1 MHz realisieren, während mit Luftschnittstellen nur Datenraten mit geringerer Datenrate realisierbar sind. Dies verbessert außerdem vorteilhaft die Qualität der optischen Signalübertagung.

Auf der anderen Seite lässt sich eine elektronische Baugruppe, bestehend aus dem Schaltungsträger, vorzugsweise einer Leiterplatte, einem Sender und einem Empfänger, kostengünstig herstellen. Auch das Lichtleitelement muss nicht aufwändig mit dem Sender und dem Empfänger gekoppelt werden, sondern wird erfindungsgemäß selber als SMD-Bauteil ausgeführt und kann daher während des Bestückprozesses der Leiterplatte sozusagen gleich mit montiert werden. Vorzugsweise werden Sender, Empfänger und Lichtleiter in einem ersten Schritt zu einem SMD-Bauteil zusammengebaut. Dies geschieht mit automatischen Bestückverfahren und auf eine hochgenaue Justage des Lichtleiters kann in der Regel verzichtet werden. Anschließend kann dieses neue Bauelement mit Standardbestückverfahren in SMT verarbeitet werden, wenn die Baugruppe selbst als SMD-Bauteil ausgeführt ist. Hierdurch wird in einem Verfahrensstadium, in dem ohnehin die Montage von SMD-Bauteilen erforderlich ist, auch der Lichtwellenleiter montiert, und zwar mit einer für die optische Übertragung der Signale zwischen Sender und Empfänger genügenden Lagegenauigkeit. Hierdurch kann eine verhältnismäßig kostengünstige und im Betrieb sichere Baugruppe entstehen, die gleichzeitig eine hohe geforderte optische Übertragungsgüte und Übertragungsrate aufweist.

Zur Verbesserung der Übertragungsgüte kann das Lichtleitelement aus optischen Medien mit unterschiedlicher optischer Dichte hergestellt werden, wobei die Lichtleitung über einen Kern (core) mit einer höheren Brechzahl erfolgt, welches von einer Ummantelung (cladding) mit einer kleineren Brechzahl umgeben ist. Dieser Aufbau ist an sich bekannt, wird erfindungsgemäß jedoch so hergestellt, dass ein für die Oberflächenmontage geeignetes Bauelement entsteht.

Der optische Sender kann beispielsweise als Laserdiode, insbesondere VCSEL, oder LED ausgeführt sein. Der optische Empfänger kann durch eine Fotodiode gebildet sein. Die jeweiligen Enden des Wellenleiters sind so ausgeführt, dass das Licht des Senders eingekoppelt und auf der gegenüberliegenden Seite des Wellenleiters zum Empfänger hin ausgekoppelt werden kann. Hierzu können die entsprechenden Stirnseiten des Wellenleiters genutzt werden, die vorteilhaft zu diesem Zweck mit einer geringen Oberflächenrauheit ausgestattet sind (zu erzeugen beispielsweise durch Polieren). Der Wellenleiter kann kostengünstig hergestellt werden, indem beispielsweise eine Zweikomponenten-Spritztechnik angewendet wird. Hierbei wird der Kern in einer Form mit der Hülle umspritzt.

Eine andere Möglichkeit besteht darin, den optischen Wellenleiter aus Dünnglas herzustellen. Der Wellenleiter kann auch durch einen Ionenätzprozess erzeugt werden. Möglich ist auch die Strukturierung von Polymerwellenleitern durch Mehrphotonenabsorption. Zuletzt lässt sich mithilfe von Masken der Polymerwellenleiter auch fotolithografisch erzeugen.

Der Schaltungsträger weist außerdem eine Verdrahtungsebene für den Sender und den Empfänger auf. Diese kann beispielsweise durch eine strukturierte Leiterbahnlage (z. B. aus Kupfer) auf dem Schaltungsträger ausgebildet werden. Wenn der Schaltungsträger seinerseits mit einem Bauteil elektrisch verbunden werden soll, so ist gemäß einer weiteren Ausgestaltung der Erfindung vorgesehen, dass der Schaltungsträger Kontaktstrukturen für eine SMD-Montage auf einer elektrischen Baugruppe aufweist. Diese Baugruppe kann beispielsweise eine leistungselektronische Baugruppe mit einem galvanischen Graben sein, wobei der Optokoppler nach Montage den galvanischen Graben überbrückt und sicherstellt, dass zwischen den beidseits des galvanischen Grabens liegenden Schaltungen keine elektrische Verbindung besteht.

Gemäß einer vorteilhaften Ausgestaltung der Erfindung verläuft die Übertragungsstrecke am Sender und/oder am Empfänger parallel zum Schaltungsträger. Dies bedeutet, dass die Abstrahlungsrichtung des Senders selbst auch parallel zur Oberfläche des Schaltungsträgers verlaufen kann bzw. die lichtempfindliche Fläche des Empfängers senkrecht zur Montageseite des Schaltungsträgers verlaufen kann, so dass das Signal der Übertragungsstrecke folgend parallel zur Montageseite des Schaltungsträgers verlaufen kann. Hierdurch ist vorteilhaft eine einfache Montage und einfache Geometrie des Lichtleitelementes möglich. Für den Sender und den Empfänger können vorzugsweise gehäuste Bauelemente verwendet werden, welche als standardisierte Elemente verfügbar sind.

Gemäß einer anderen Ausgestaltung der Erfindung ist vorgesehen, dass der Sender und/oder der Empfänger als Bare Die Bauelemente (auch als Nacktchips oder ungehäuste Halbleiterbauelemente bezeichnet) ausgeführt sind, wobei die Übertragungsstrecke am Bare Die Bauelement senkrecht zum Schaltungsträger verläuft und durch das Lichtleitelement zweimal umgelenkt wird. Im Lichtleitelement selbst verläuft das Licht damit parallel zur Montageseite des Schaltungsträgers, wobei die Umlenkung infolge dessen um jeweils 90° erfolgt. Als notwendige Reflexionsflächen können die Enden des Lichtleitelementes jeweils um 45° abgeschrägt und beispielsweise poliert werden, so dass an diesen Oberflächen im Lichtleitelement eine Totalreflexion (auch als innere Totalreflexion, kurz TIR bezeichnet) erfolgt. Die Verspiegelung zum Umlenken kann zusätzlich mit einer Beschichtung des Lichtleitelementes von außen versehen werden. Mit und ohne Verspiegelung ist vorteilhaft eine einfache Fertigung des funktionsintegrierten Lichtleitelementes möglich, welches vorteilhaft in großer Stückzahl zu geringen Fertigungskosten hergestellt werden kann.

Die Kontaktstrukturen können vorteilhaft auf der Montageseite des Schaltungsträgers für den Sender, Empfänger und das Lichtleitelement oder auf der dieser Montageseite gegenüberliegenden Rückseite des Schaltungsträgers vorgesehen werden. Kontaktstrukturen auf der Rückseite ermöglichen die Montage des Optokopplers auf einem planen Trägerbauteil einer elektronischen Baugruppe. Dieses Trägerbauteil kann beispielsweise ein Gehäuse oder auch eine Leiterplatte sein. Sind die Kontaktstrukturen auf der Montageseite des Schaltungsträgers montiert, so wird dieser mit zur Baugruppe weisenden Bauelementen (d. h. Sender, Empfänger, Lichtleitelement) montiert. Zu diesem Zweck muss das Trägerbauteil der elektronischen Baugruppe eine Vertiefung aufweisen, in der die Bauelemente des Optokopplers Platz finden.

Gemäß einer besonderen Ausgestaltung der Erfindung kann vorgesehen werden, dass das Lichtleitelement auf einem Tragkörper befestigt ist, welcher seinerseits auf dem Schaltungsträger montiert ist. Der Tragkörper kann insbesondere zur Überbrückung einer notwendigen Distanz zwischen dem Lichtleitelement und dem Schaltungsträger dienen. Diese Distanz kann aufgrund baulicher Vorgaben notwendig werden, um die erforderliche Geometrie des Strahlengangs zu gewährleisten. Diese kann beispielsweise durch die Abstrahlungshöhe von gehäusten Bauelementen oder auch durch die Notwendigkeit einer Umlenkung des Strahlengangs von einer zur Montageseite des Schaltungsträgers parallelen Ausrichtung zu einer senkrechten Ausrichtung und andersherum entstehen. Der Tragkörper kann dabei beispielsweise aus dem Material der Hülle gebildet sein oder vorteilhaft auch aus einem kostengünstigeren Material, so dass das Lichtleitelement aus drei unterschiedlichen Komponenten besteht.

Eine weiterführende Ausgestaltung der Erfindung wird erhalten, wenn der optische Empfänger als elektrooptischer Wandler ausgeführt ist und mit einem elektrischen Energiespeicher und/oder einer elektrischen Versorgung eines elektrischen Verbrauchers, also beispielsweise elektrischen Kontakten eines elektrischen Verbrauchers verbunden ist. Erfindungsgemäß kann die durch den optischen Empfänger zur Verfügung gestellte Energie somit auch zur Energieversorgung von elektronischen Komponenten dienen, die aufgrund einer erforderlichen galvanischen Trennung von extern nicht mit elektrischer Energie versorgt werden dürfen. Gemäß dieser Ausgestaltung der Erfindung dient der Optokoppler also der Übertragung von Energie, wobei diese in einem elektrischen Energiespeicher zwischengespeichert werden kann oder direkt zum Betrieb der elektronischen Komponenten verwendet werden kann. Dabei ist es möglich, dass der Optokoppler gleichzeitig zur Übertragung von Signalen dient. Alternativ kann zum Übertragen der Signale ein anderer Optokoppler verwendet werden. Die Optokoppler können auch Signale in beiden Richtungen übertragen (Duplexbauweise). In diesem Falle ist auf jeder Seite je ein optischer Sender und ein optischer Empfänger vorzusehen.

Noch eine Ausführung der Erfindung wird erhalten, wenn der Schaltungsträger eine Einbauvertiefung aufweist, in der der Sender, der Empfänger und das Lichtleitelement angeordnet sind. Hierdurch werden die Bauelemente vorteilhaft durch den Schaltungsträger geschützt. Und es kann ein Bauraum für den Optokoppler gespart werden.

Die Aufgabe wird mittels der eingangs erwähnten elektronischen Baugruppe gelöst, indem ein Optokoppler der bereits beschriebenen Art in der elektronischen Baugruppe montiert ist, der die optische Übertragungsstrecke zur Verfügung stellt. Die mit dem Betrieb dieser Baugruppe verbundenen Vorteile ergeben sich aus der Verwendung des erfindungsgemäßen Optokopplers und sind bereits beschrieben worden.

Mit Vorteil wird die erste Schaltung dieser Baugruppe mit einer höheren Spannung und/oder einer höheren Leistung betrieben, als die zweite Schaltung. Daraus ergeben sich bevorzugte Anwendungsfälle wie z. B. Schaltschränke für leistungselektronische Bauelemente, die in geeigneter Weise angesteuert werden müssen. Die Schaltung mit der höheren Spannung und/oder höheren Leistung ist zur Bewältigung einer leistungselektronischen Aufgabe vorgesehen. Die Ansteuerung erfolgt über die zweite Schaltung, welche lediglich der Verarbeitung von Informationen dient. Diese Informationen werden optisch über einen galvanischen Graben zur ersten Schaltung transportiert, um dort beispielsweise eine Steuerung zu implementieren.

Die erfindungsgemäße Baugruppe sieht vor, dass diese ein Trägerbauteil mit einer Vertiefung aufweist, wobei die Vertiefung als Einbauraum für den Optokoppler dient. Kontaktelemente zur Kontaktierung des Optokopplers auf dem Trägerbauteil sind dann genauso wie die optischen Bauelemente (Sender, Empfänger, Lichtleitelement) auf der Montageseite des Schaltungsträgers vorgesehen. Nach einer Montage des Schaltungsträgers ragen die Bauelemente des Optokopplers daher in die Vertiefung hinein. Diese Vertiefung kann vorteilhaft auch eine Stufe aufweisen, wobei diese Stufe zur elektrischen Kontaktierung des Optokopplers über die Kontaktstrukturen dient. Damit weist die der Montageseite gegenüberliegende Rückseite des Schaltungsträgers vorzugsweise dasselbe Niveau auf, wie die Oberfläche des Trägerbauteiles. Der Schaltungsaufbau des Optokopplers reicht dann in den tieferen Teil der Vertiefung hinein, der sich unterhalb der Stufe befindet.

Weitere Einzelheiten der Erfindung werden nachfolgend anhand der Zeichnung beschrieben. Gleiche oder sich entsprechende Zeichnungselemente sind jeweils mit dem gleichen Bezugszeichen versehen und werden nur insoweit mehrfach erläutert, wie sich Unterschiede zwischen den einzelnen Figuren ergeben. Es zeigen:
- Fig. 1 und 2: Ausführungsbeispiele der erfindungsgemäßen Baugruppe mit Ausführungsbeispielen des erfindungsgemäßen Optokopplers jeweils im Schnitt und
- Figur 3: ein weiteres Ausführungsbeispiel der erfindungsgemäßen Baugruppe mit mehreren Ausführungsbeispielen des erfindungsgemäßen Optokopplers schematisch als Aufsicht.

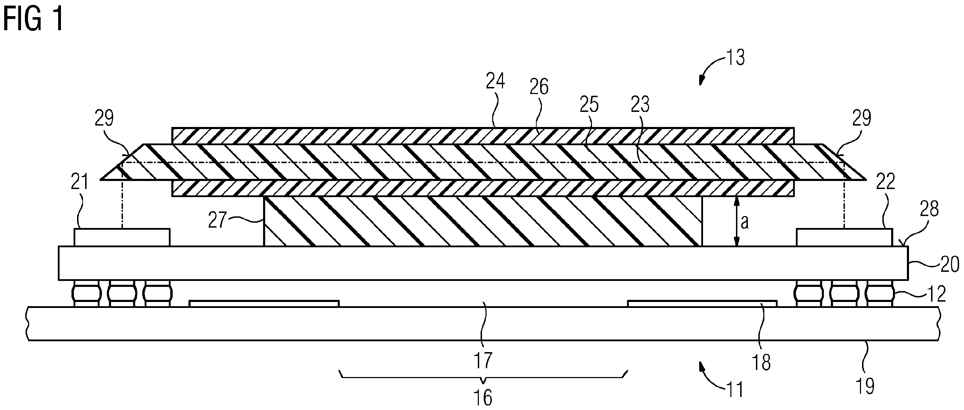

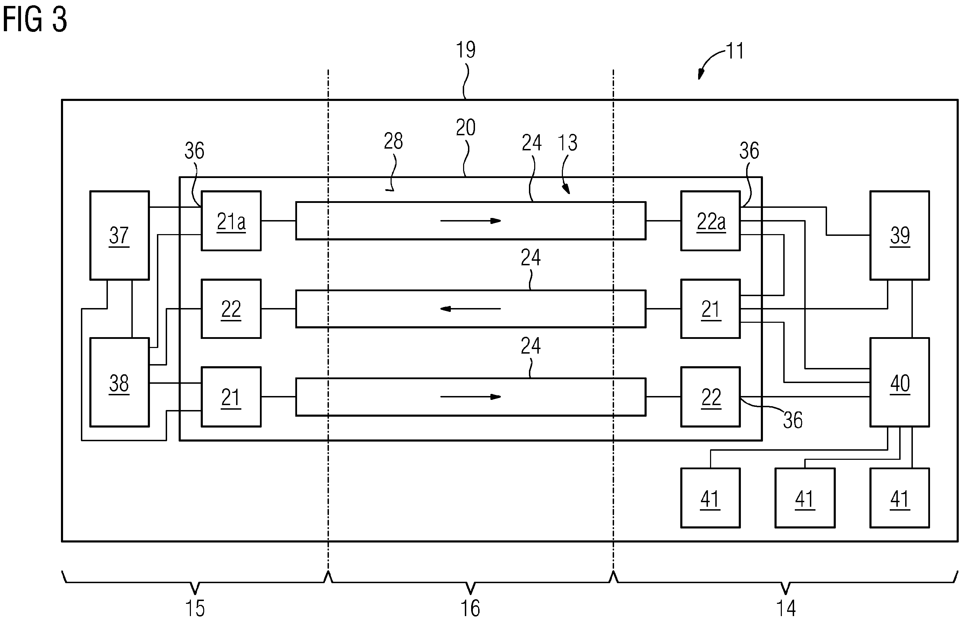

In Figur 1 ist eine elektronische Baugruppe 11 dargestellt, auf der über Kontaktstrukturen 12 ein Optokoppler 13 elektrisch kontaktiert und befestigt ist, wobei dieser somit Teil der Baugruppe 11 ist. Die Baugruppe 11 weist, wie sich Figur 3 entnehmen lässt, eine erste Schaltung 14 und eine zweite Schaltung 15 auf, wobei diese durch eine galvanische Trennung in Form eines galvanischen Grabens 16 galvanisch voneinander getrennt sind. Dieser galvanische Graben ist auch in Figur 1 dargestellt und wird von dem Optokoppler überbrückt. Der galvanische Graben 16 gemäß Figur 1 wird durch eine Unterbrechung 17 einer Kupfermetallisierung 18 eines Tragkörpers 19 in Form einer Leiterplatte gebildet, wobei der Tragkörper 19 den Aufbau der elektronischen Schaltung trägt (in Figur 1 nicht dargestellt, vgl. aber Figur 3). Der Optokoppler 13 ist auf einem Schaltungsträger 20 aufgebaut. Dieser weist einen Sender 21 und einen Empfänger 22 auf, wobei die vom Sender ausgehenden optischen Signale entlang eines strichpunktiert angedeuteten Strahlenganges 23 in ein Lichtleitelement 24 eingekoppelt und am Empfänger 22 wieder ausgekoppelt wird. Das Lichtleitelement weist zu diesem Zweck einen Lichtleiter auf, welcher aus einem Kern 25 und einer Hülle 26 besteht. Der Lichtleiter wird über einen Tragkörper 27 auf dem Schaltungsträger montiert. Der Tragkörper 27 garantiert einen Abstand a zwischen dem Lichtleiter und dem Sender 21 bzw. Empfänger 22, so dass Lichtsignale eingekoppelt bzw. ausgekoppelt werden können.

Der Sender 21 und der Empfänger 22 sind als Bare Die Bauelemente ausgeführt und weisen eine Strahlrichtung auf, die senkrecht auf einer Montageseite 28 des Schaltungsträgers 20 steht. Da der Strahlengang in dem Kern 25 parallel zur Montageseite 28 verläuft, ist eine Umlenkung des Strahlenganges in dem Kern notwendig. Dies wird durch Reflexionsflächen 29 erreicht, die in einem Winkel von 45° zur Montageseite 28 ausgerichtet sind.

Das Trägerbauteil 19 in Figur 1 ist als Leiterplatte dargestellt. Diese kann zum Beispiel aus einem FR4-Material bestehen. Nicht dargestellt, jedoch auch denkbar ist es, dass das Trägerbauteil 19 nicht plattenförmig ausgebildet ist, sondern eine dreidimensionale Struktur, beispielsweise ein Gehäusebauteil ausbildet. Der Kern 25, der als Wellenleiter dient, soll aus einem möglichst temperaturstabilen Material, z. B. einem Cyclo-Olefin-Polymer (COP, Markenname: Zeonex^{®}) bestehen. Als Material für die Hülle eignet sich beispielsweise Polyetherimid (PEI, Markenname: Ultem^{®}). Der Tragkörper kann beispielweise aus FR4 oder einem anderen reflowfähigen Kunststoff bestehen.

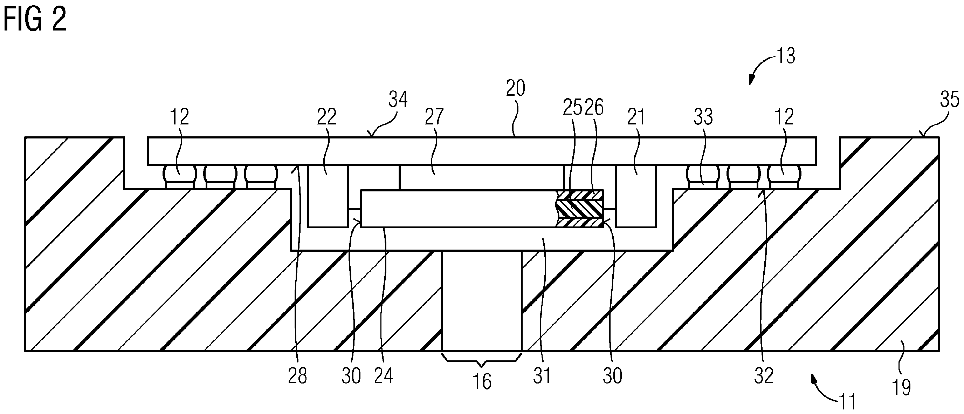

In Figur 2 kommt ein Optokoppler 13 zum Einsatz, bei dem der Sender 21 und der Empfänger 22 als gehäuste Bauelemente ausgebildet sind. Der Sender kann beispielsweise durch eine Leuchtdiode und der Empfänger durch eine Fotodiode ausgebildet sein. Die Abstrahlrichtung des Senders 21 und bevorzugte "Empfangsrichtung" des Empfängers 22 verlaufen jeweils parallel zur Montageseite 28 des Schaltungsträgers 20. Daher kommt das Lichtleitelement 24 anders als in Figur 1 ohne Reflexionsflächen aus und das Signal wird jeweils an Stirnseiten 30 des Lichtleitelementes 24 ein- bzw. ausgekoppelt.

Ein weiterer Unterschied zu dem Optokoppler 13 gemäß Figur 1 besteht darin, dass die Kontaktstrukturen 12 zur Montage auf dem Trägerbauteil 19 auf der Montageseite 28 des Schaltungsträgers 20 vorgesehen sind. Dies bedeutet, dass der Optokoppler 13 mit der bestückten Seite zum Trägerbauteil 19 gewandt montiert wird. Zu diesem Zweck ist in dem Trägerbauteil 19 eine Vertiefung 31 vorgesehen, in der der Sender 21, der Empfänger 22 und das Lichtleitelement 24 Platz finden. Die Kontaktstrukturen 12 werden dabei auf einer Stufe 32 in der Vertiefung 31 montiert, wobei hierfür Kontaktflächen 33 vorgesehen sind. Damit befindet sich eine der Montageseite 28 abgewandte Rückseite 34 des Schaltungsträgers in einer Ebene mit einer Oberseite 35 des Trägerbauteiles 19.

Der galvanische Graben 16 ist bei dem Trägerbauteil 19 als Fortführung der Vertiefung 31 ausgebildet. Er bildet dadurch eine Isolationsstrecke, die mit Luft oder einem anderen Gas gefüllt ist. Alternativ kann diese auch mit einem festen Isolationsmaterial gefüllt sein (nicht dargestellt).

Statt der Vertiefung in dem Trägerbauteil 19 kann auch der Schaltungsträger eine Einbauvertiefung aufweisen, in der der Sender 21, der Empfänger 22 und das Lichtleitelement 24 angeordnet sind (nicht dargestellt). Die Anordnung dieser Bauelemente selbst könnte genau, wie in Figur 2 dargestellt, erfolgen. Die Einbauvertiefung kann dem Trägerbauteil im montierten Zustand des Schaltungsträgers zugewandt sein (dann liegen die optischen Bauelemente besonders geschützt) oder abgewandt sein.

In Figur 3 ist die elektronische Baugruppe 11 vereinfacht dargestellt. Der galvanische Graben 16 ist lediglich durch Strichpunktlinien angedeutet und trennt die erste Schaltung 14, die als leistungselektronische Schaltung ausgeführt ist, von der zweiten Schaltung 15, die aus einer Steuerschaltung besteht. Der galvanische Graben 16 wird von drei Lichtleitelementen 24 überbrückt, durch die optischen Signale jeweils in Richtung der angedeuteten Pfeile übertragen werden. Alternativ zu einer Übertragung von Licht in mehreren Lichtleitelementen 24 ist es auch möglich, eine Duplexanordnung vorzusehen, bei der ein Lichtleitelement, wie in Figur 1 und 2 dargestellt, das Licht in beide Richtungen überträgt. Zu diesem Zweck sind an beiden Enden des Lichtleitelementes sowohl ein Empfänger als auch ein Sender anzuordnen.

Zu erkennen in Figur 3 sind weiterhin Anschlüsse 36 an den Sendern 21, 21A und Empfängern 22, 22A, über die elektrischen Verbindungen zu anderen Bauelementen hergestellt werden. Die zweite Schaltung besteht aus einer Spannungsquelle 37 und einer Steuerung 38, wobei die Spannungsquelle 37 die Energieversorgung übernimmt, während die Steuerung 38 über den angeschlossenen Sender 21 Steuersignale an die erste Schaltung 14 sendet und über den angeschlossenen Empfänger 22 Signale der ersten Schaltung 14 empfängt. Außerdem wird durch die Steuerung 38 der Sender 21A angesteuert, der nicht zur Übermittlung von Informationen, sondern zur Übertragung von Leistung an den Empfänger 22A dient. Auf diesem Wege wird ein Energiespeicher 39 der ersten Schaltung mit elektrischer Energie versorgt, wobei auch eine Steuerung 40 direkt an den Empfänger 22A angeschlossen ist. Dies gilt auch für den Sender 21, der ebenfalls direkt von dem Empfänger 22A oder alternativ von dem Energiespeicher 39 mit elektrischer Energie versorgt werden kann.

Die Steuerung 40 ist zum Betrieb von Leistungsbauelementen 41 vorgesehen. Zu diesem Zweck werden auch Steuersignale der Steuerung 38 verarbeitet, die über den Empfänger 22 auf der Seite der ersten Schaltung 14 zur Verfügung gestellt werden.

Die Steuerung 40 kann über den angeschlossenen Sender 21 auch mit der Steuerung 38 kommunizieren.

## Patentansprüche

1. Elektronische Baugruppe (11) mit einer ersten Schaltung (14) und einer zweiten Schaltung (15),
wobei die erste Schaltung (14) galvanisch von der zweiten Schaltung (15) getrennt ist und
wobei zwischen der ersten Schaltung (14) und der zweiten Schaltung (15) eine optische Übertragungsstrecke vorgesehen ist,
wobei ein Optokoppler die optische Übertragungsstrecke zur Verfügung stellt,
wobei der Optokoppler (13) einen Sender (21) und einen Empfänger (22) aufweist, die durch die optische Übertragungsstrecke miteinander gekoppelt sind, wobei der Optokoppler (13) elektrische Anschlüsse am Sender und am Empfänger sowie einen Schaltungsträger (20) aufweist,
wobei der Sender (21) und der Empfänger (22) als SMD-Bauteile ausgeführt sind und auf dem Schaltungsträger (20) montiert sind,
wobei Lichtsignale des Senders (21) in ein Lichtleitelement (24) einkoppelbar sind und aus dem Lichtleitelement (24) ausgekoppelbare Lichtsignale auf den Empfänger (22) gerichtet sind, und
wobei der Schaltungsträger (20) eine Einbauvertiefung aufweist, in der der Sender (21) und das Lichtleitelement (24) angeordnet sind,
**dadurch gekennzeichnet,**
**dass** in der Einbauvertiefung der Empfänger (22) angeordnet ist,
**dass** das sich in der optischen Übertragungsstrecke befindende Lichtleitelement (24) als SMD-Bauteil ausgeführt ist und auf dem Schaltungsträger (20) montiert ist,
die erste Schaltung (14) eingerichtet ist, mit einer höheren Spannung und/oder einer höheren Leistung betrieben zu werden als die zweite Schaltung (15), wobei die erste Schaltung (14) als leistungselektronische Schaltung ausgeführt ist und eine Steuerung (40) aufweist, die zum Betrieb von Leistungsbauelementen (41) vorgesehen ist, und
die zweite Schaltung lediglich der Verarbeitung von Informationen dient, welche optisch über einen galvanischen Graben zur ersten Schaltung transportiert werden.

2. Elektronische Baugruppe (11) nach Anspruch 1,
**dadurch gekennzeichnet,**
**dass** die Übertragungsstrecke am Sender (21) und/oder am Empfänger (22) parallel zum Schaltungsträger (20) verläuft, sodass die Abstrahlungsrichtung des Senders (21) parallel zur Oberfläche des Schaltungsträgers (20) bzw. die lichtempfindliche Fläche des Empfängers (22) senkrecht zur Montageseite des Schaltungsträgers (20) verlaufen kann.

3. Elektronische Baugruppe (11) nach Anspruch 1,
**dadurch gekennzeichnet,**
**dass** der Sender (21) und/oder der Empfänger (22) als ungehäuste Halbleiterbauelemente ausgeführt sind, wobei die Übertragungstrecke sowohl am Sender (21) als auch am Empfänger (22) senkrecht zum Schaltungsträger (20) verläuft und durch das Lichtleitelement (24) zweimal umgelenkt wird und im Lichtleitelement (24) parallel zum Schaltungsträger (20) verläuft.

4. Elektronische Baugruppe (11) nach einem der voranstehenden Ansprüche,
**dadurch gekennzeichnet,**
**dass** der Schaltungsträger (20) Kontaktstrukturen (12) für eine SMD-Montage auf einer elektronischen Baugruppe (11) aufweist.

5. Elektronische Baugruppe (11) nach einem der voranstehenden Ansprüche,
**dadurch gekennzeichnet,**
**dass** das Lichtleitelement (24) durch einen Lichtleiter, aufweisend einen Kern (25) und eine Hülle (26), gebildet ist.

6. Elektronische Baugruppe (11) nach Anspruch 5,
**dadurch gekennzeichnet,**
**dass** der Lichtleiter an mindestens einem der Enden eine Strahlumlenkung in Form einer Reflexionsfläche (29) vorgesehen ist.

7. Elektronische Baugruppe (11) nach einem der voranstehenden Ansprüche,
**dadurch gekennzeichnet,**
**dass** das Lichtleitelement (24) auf einem Tragkörper (27) befestigt ist, welcher seinerseits auf dem Schaltungsträger (20) montiert ist.

8. Elektronische Baugruppe (11) nach einem der voranstehenden Ansprüche,
**dadurch gekennzeichnet,**
**dass** der optische Empfänger (22a) als elektrooptischer Wandler ausgeführt ist und mit einem elektrischen Energiespeicher (39) und/oder einer elektrischen Versorgung eines elektrischen Verbrauchers verbunden ist.

9. Elektronische Baugruppe (11) nach einem der voranstehenden Ansprüche,
**dadurch gekennzeichnet,**
**dass** mehrere Lichtleitelemente (24) vorgesehen sind.

10. Elektronische Baugruppe (11) nach einem der voranstehenden Ansprüche,
**dadurch gekennzeichnet,**
**dass** diese ein Trägerbauteil (19) mit einer Vertiefung (31) aufweist, wobei die Vertiefung (31) als Einbauraum für den Optokoppler dient.

11. Elektronische Baugruppe (11) nach Anspruch 10,
**dadurch gekennzeichnet,**
**dass** die Vertiefung (31) eine Stufe (32) mit Kontaktflächen (33) aufweist, wobei der Optokoppler über die Kontaktflächen (33) elektrisch kontaktiert ist.

## Claims

1. Electronic assembly (11) comprising a first circuit (14) and a second circuit (15),
wherein the first circuit (14) is galvanically isolated from the second circuit (15) and
wherein an optical transmission link is provided between the first circuit (14) and the second circuit (15),
wherein an optocoupler makes the optical transmission link available,
wherein the optocoupler (13) has a transmitter (21) and a receiver (22), which are coupled to one another by the optical transmission link, wherein the optocoupler (13) has electrical connections at the transmitter and at the receiver and also has a circuit carrier (20),
wherein the transmitter (21) and the receiver (22) are embodied as SMD components and are mounted on the circuit carrier (20),
wherein light signals of the transmitter (21) are able to be coupled into a light guiding element (24) and light signals which are able to be coupled out of the light guiding element (24) are directed at the receiver (22), and
wherein the circuit carrier (20) has an installation depression in which the transmitter (21) and the light guiding element (24) are arranged,
**characterized**
**in that** the receiver (22) is arranged in the installation depression,
**in that** the light guiding element (24) situated in the optical transmission link is embodied as an SMD component and is mounted on the circuit carrier (20),
the first circuit (14) is configured to be operated with a higher voltage and/or a higher power than the second circuit (15), wherein the first circuit (14) is embodied as a power electronic circuit and has a controller (40) provided for the operation of power components (41), and
the second circuit serves merely for the processing of information that is transported optically via a galvanic trench to the first circuit.

2. Electronic assembly (11) according to Claim 1,
**characterized**
**in that** the transmission link at the transmitter (21) and/or at the receiver (22) extends parallel to the circuit carrier (20), such that the emission direction of the transmitter (21) can extend parallel to the surface of the circuit carrier (20) or the light-sensitive surface of the receiver (22) can extend perpendicular to the mounting side of the circuit carrier (20) .

3. Electronic assembly (11) according to Claim 1,
**characterized**
**in that** the transmitter (21) and/or the receiver (22) are/is embodied as unpackaged semiconductor components, wherein the transmission link both at the transmitter (21) and at the receiver (22) extends perpendicular to the circuit carrier (20) and is deflected twice by the light guiding element (24) and in the light guiding element (24) extends parallel to the circuit carrier (20).

4. Electronic assembly (11) according to any of the preceding claims,
**characterized**
**in that** the circuit carrier (20) has contact structures (12) for SMD mounting on an electronic assembly (11).

5. Electronic assembly (11) according to any of the preceding claims,
**characterized**
**in that** the light guiding element (24) is formed by a light guide, having a core (25) and a cladding (26).

6. Electronic assembly (11) according to Claim 5,
**characterized**
**in that** at the light guide at at least one of the ends a beam deflection in the form of a reflection surface (29) is provided.

7. Electronic assembly (11) according to any of the preceding claims,
**characterized**
**in that** the light guiding element (24) is secured on a carrying body (27), which for its part is mounted on the circuit carrier (20).

8. Electronic assembly (11) according to any of the preceding claims,
**characterized**
**in that** the optical receiver (22a) is embodied as an electro-optical transducer and is connected to an electrical energy store (39) and/or an electrical supply of an electrical consumer.

9. Electronic assembly (11) according to any of the preceding claims,
**characterized**
**in that** a plurality of light guiding elements (24) are provided.

10. Electronic assembly (11) according to any of the preceding claims,
**characterized**
**in that** said electronic assembly has a carrier component (19) having a depression (31), wherein the depression (31) serves as installation space for the optocoupler.

11. Electronic assembly (11) according to Claim 10,
**characterized**
**in that** the depression (31) has a step (32) with contact pads (33), wherein the optocoupler is electrically contacted via the contact pads (33).

## Revendications

1. Module (11) électronique comprenant un premier circuit (14) et un deuxième circuit (15),
dans lequel le premier circuit (14) est séparé galvaniquement du deuxième circuit (15) et
dans lequel un chemin de transmission optique est prévu entre le premier circuit (14) et le deuxième circuit (15),
dans lequel un optocoupleur met le chemin de transmission optique à disposition,
dans lequel l'optocoupleur (13) a un émetteur (21) et un récepteur, (22) qui sont reliés entre eux par le chemin de transmission optique,
dans lequel l'optocoupleur (13) a des bornes électriques à l'émetteur et au récepteur ainsi qu'un support (20) de circuit, dans lequel l'émetteur (21) et le récepteur (22) sont réalisés sous la forme de composants SMD et sont montés sur le support (20) de circuit,
dans lequel les signaux lumineux de l'émetteur (21) peuvent être injectés dans un élément (24) de guidage de la lumière et des signaux lumineux, pouvant sortir de l'élément (24) de guidage de la lumière, sont dirigés sur le récepteur (22), et
dans lequel le support (20) de circuit a une cavité de montage, dans laquelle sont montés l'émetteur (21) et l'élément (24) de guidage de la lumière,
**caractérisé**
**en ce que** le récepteur (22) est disposé dans la cavité de montage, en ce que l'élément (24) de guidage de la lumière, se trouvant dans le chemin de transmission optique, est réalisé en composant SMD et est monté sur le support (20) de circuit,
le premier circuit (14) est conçu pour fonctionner à une tension plus haute et/ou à une puissance plus grande que le deuxième circuit (15), dans lequel le premier circuit (14) est réalisé sous la forme d'un circuit d'électronique de puissance et a une commande (40), qui est prévue pour le fonctionnement de composants (41) de puissance, et
le deuxième circuit sert seulement au traitement d'informations, qui sont transportées optiquement vers le premier circuit par une tranchée galvanique.

2. Module (11) électronique suivant la revendication 1,
**caractérisé**
**en ce que** le chemin de transmission s'étend à l'émetteur (21) et/ou au récepteur (22), parallèlement au support (20) de circuit, de sorte que la direction de sortie du rayonnement de l'émetteur (21) puisse s'étendre parallèlement à la surface du support (20) de circuit et respectivement, de manière à ce que la surface de réception de la lumière de récepteur (22) puisse s'étendre perpendiculairement à la face de montage du support (20) de circuit.

3. Module (11) électronique suivant la revendication 1,
**caractérisé**
**en ce que** l'émetteur (21) et/ou le récepteur (22) sont réalisés sous la forme de composants à semiconducteur sans boîtier, dans lequel le chemin de transmission s'étend, tant à l'émetteur (21) qu'également au récepteur (22), perpendiculairement au support (20) de circuit, et est dévié deux fois par l'élément (24) de guidage de la lumière, et s'étend dans l'élément (24) de guidage de la lumière, parallèlement au support (20) de circuit.

4. Module (11) électronique suivant l'une des revendications précédentes,
**caractérisé**
**en ce que** le support (20) de circuit a des structures (12) de contact pour un montage SMD sur un module (11) électronique.

5. Module (11) électronique suivant l'une des revendications précédentes,
**caractérisé**
**en ce que** l'élément (24) de guidage de la lumière est formé par une fibre optique ayant un cœur (25) et une gaine (26).

6. Module (11) électronique suivant la revendication 5,
**caractérisé**
**en ce qu'**il est prévu, à au moins l'un des bouts de la fibre optique, une déviation du rayonnement sous la forme d'une surface (29) de réflexion.

7. Module (11) électronique suivant l'une des revendications précédentes,
**caractérisé**
**en ce que** l'élément (24) de guidage de la lumière est fixé à un corps (27) support, lequel est monté, de son côté, sur le support (20) de circuit.

8. Module (11) électronique suivant l'une des revendications précédentes,
**caractérisé en ce que**
le récepteur (22a) optique est réalisé sous la forme d'un transducteur électrooptique et est relié à un accumulateur (39) d'énergie électrique et/ou à une alimentation électrique d'un consommateur électrique.

9. Module (11) électronique suivant l'une des revendications précédentes,
**caractérisé**
**en ce qu'**il est prévu plusieurs éléments (24) de guidage de la lumière.

10. Module (11) électronique suivant l'une des revendications précédentes,
**caractérisé**
**en ce que** celui-ci a un composant (19) de support ayant une cavité (31), dans lequel la cavité (31) sert d'espace de montage de l'optocoupleur.

11. Module (11) électronique suivant la revendication 10,
**caractérisé en ce que**
la cavité (31) a une marche (32) ayant des surfaces (33) de contact, dans lequel l'optocoupleur est mis en contact électriquement par les surfaces (33) de contact.
